# EUROPÄISCHE PATENTANMELDUNG

(11) **EP 3 001 318 A1**
(43) Veröffentlichungstag der Anmeldung: **30.03.2016**
(21) Anmeldenummer: 14186124.5
(22) Anmeldetag: 24.09.2014
(51) Int. Cl.: G06F 11/36, G06F 17/50

(54) **Bestimmung von Signalen für Readback aus FPGA**

(71) Anmelder: dSPACE digital signal processing and control engineering GmbH, 33102 Paderborn (DE)
(72) Erfinder: Kalte, Heiko, 33106 Paderborn (DE); Funke, Lukas, 33102 Paderborn (DE)

(57) **Zusammenfassung**

Die Erfindung betrifft ein Verfahren zur automatischen Bestimmung von Modellsignalen eines FPGA-Programms, die nach einem FPGA-Build (4) mit einem Readback aus dem FPGA (8) auslesbar sind, umfassend die Schritte Erzeugen eines FPGA-Modells (2), und Erzeugen eines FPGA-Codes (3) aus dem FPGA-Modell (2), wobei das Verfahren vor dem Abschluss des Schritts der Erzeugung des FPGA-Codes (3) aus dem FPGA-Modell (2) den zusätzlichen Schritt des automatischen Analysierens zur Erkennung von aus dem FPGA (8) mit einem Readback auslesbaren Signalen umfasst, und das Verfahren den Schritt des Ausgebens von aus dem FPGA (8) mit einem Readback auslesbaren Signalen umfasst. Die Erfindung betrifft außerdem eine Datenverarbeitungseinrichtung (1) zur Durchführung des obigen Verfahrens.

## Beschreibung

Die vorliegende Erfindung betrifft ein Verfahren zur automatischen Bestimmung von Modellsignalen eines FPGA-Programms, die nach einem FPGA-Build mit einem Readback aus dem FPGA auslesbar sind. Ebenfalls betrifft die Erfindung eine Datenverarbeitungseinrichtung, die Datenverarbeitungseinrichtung zur Durchführung des obigen Verfahrens ausgeführt ist. Weiterhin betrifft die Erfindung ein Computerprogrammprodukt mit Computer-implementierten Anweisungen, das nach dem Laden und Ausführen in einer geeigneten Datenverarbeitungseinrichtung die Schritte des obigen Verfahrens ausführt. Ebenfalls betrifft die Erfindung ein digitales Speichermedium mit elektronisch auslesbaren Steuersignalen, wobei die Steuersignale so mit einer programmierbaren Datenverarbeitungseinrichtung zusammenwirken können, dass das obige Verfahren ausgeführt wird.

Die Echtzeitsimulation von komplexen, dynamischen Modellen stellt aufgrund der engen zeitlichen Randbedingungen selbst an moderne Rechenknoten hohe Anforderungen. In automotiven Hardware-in-the-Loop-Simulationen (HiL) werden solche Modelle vor allem dort eingesetzt, wo schnelle Regelkreise geschlossen werden müssen. Dies ist etwa bei der Simulation von Zylinderinnendrucksensoren der Fall, die bei der Verbrauchs- oder Abgasreduktion eine zunehmend größere Rolle spielen. Aber auch bei Regelstrecken, die eine hohe Dynamik aufweisen, wie zum Beispiel bei Elektromotoren, sind kurze Zykluszeiten und geringe Latenzen unabdingbar. Diese können mit CPU-basierten Simulationen praktisch kaum mehr umgesetzt werden.

Field Programmable Gate Arrays (FPGAs) können Rechenknoten bei der Echtzeitsimulation unterstützen, indem sie die Berechnung von dynamischen Teilen eines Modells übernehmen. Durch die hohe Flexibilität und die Möglichkeit der Parallelverarbeitung von Signalen lassen sich durch den Einsatz von FPGAs auch harte Echtzeitanforderungen leicht erfüllen. Die FPGAs können als Hardwarebeschleuniger für CPUs von Rechenknoten dienen. Eine solche Erweiterung für einen HiL-Simulator stellt beispielsweise das DS5203-FPGA Board von dSPACE dar. Entsprechend werden z.B. sehr dynamische Teile des Umgebungsmodells in das FPGA ausgelagert, so dass ausreichend präzise und schnelle Reaktionszeiten für das Steuergerät gewährleistet bleiben. Eine FPGA Hardware-Konfiguration, in Anlehnung an die Erstellung von allgemeinen Programmen auch als FPGA-Code bezeichnet, wird üblicherweise basierend auf einem FPGA Modell in einer Hardwarebeschreibungssprache in einem Build-Prozess erzeugt.

Die Modelle einer Regelstrecke werden durch steigende Anforderungen an die Genauigkeit zunehmend komplexer und somit auch schwer handhabbar. Im automotiven Hil-Umfeld werden solche Modelle in der Regel mit dem Toolset Matlab/Simulink von The MathWorks Inc. erstellt. Simulink bietet eine blockbasierte Sicht in der Form eines Blockschaltbilds auf solche Modelle. Modellteile können in einem Blockschaltbild zu Subsystemen zusammengefasst und untereinander mit Signalen verknüpft werden. Der Datenfluss zwischen diesen Blöcken wird dabei über Signalleitungen dargestellt.

In einer CPU-basierenden Echtzeitsimulation wird das Blockschaltbild eines Modells mit Hilfe des Simulink Coders zunächst in C/C++ Quelldateien übersetzt. Diese werden anschließend über einen Compiler in eine ausführbare Applikation übersetzt, die auf einem Rechenknoten mit einem echtzeitfähigen Betriebssystem ausgeführt werden kann. Zusätzlich wird bei dem CPU-Build ein Trace-File erzeugt, welches ein Topologie File mit seiner grafischen Modellierung, beispielsweise in Simulink, darstellt.

Die Übersetzung eines Modells in eine CPU-Applikation hat zur Folge, dass die Berechnungen der Simulation sequenziell, in einer festen Schrittweite ausgeführt werden. Ein konsistentes Abbild aller Modellzustände oder Modell-Variablen, wie beispielsweise Daten auf den Signalleitungen oder Ein/Ausgabewerte der Blöcke, ist damit stets im Hauptspeicher des Rechenknotens vorhanden. Durch den direkten Zugang zum Hauptspeicher können die Modell-Variablen in einem Experimentiertool wie bspw. ContolDesk analysiert und/oder manipuliert werden. Ein wahlfreier Schreib-/Lese-Zugriff auf Variablen der HiL-Simulation ist möglich. Anhand des Trace Files können Signalwerte wie z.B. Motor-Drehzahl ausgewählt und durch eine Anzeige ausgeben oder manipuliert werden. Im HiL-Umfeld fasst man diese Vorgehensweise unter den Begriffen "Messen" und "Verstellen" zusammen.

Eine FPGA-basierte Simulation kann beispielsweise unter Zuhilfenahme des Xilinx System Generator (XSG) und des FPGA-Programming Blocksets von dSPACE, analog zur CPU-basierten Simulation, in einem Blockschaltbild mit Simulink modelliert werden.

Im Gegensatz zur CPU-Simulation wird dieses Modell allerdings nicht in eine iterative Programmiersprache übersetzt, sondern in eine Hardwarebeschreibungssparache, die eine kundenspezifisch digitale Schaltung beschreibt. Die Beschreibung der kundenspezifischen Schaltung wird bei der Erzeugung des FPGA-Codes durch einen Syntheseprozess in einen FPGA-Konfigurationsdatenstrom übersetzt. Entsprechend muss jede Modell-Variable, die der Anwender messen oder verstellen möchte, durch explizite Modellierung über Signalleitungen an die Schnittstellen des FPGAs geführt werden. Im Anschluss an diese Anpassung muss das Modell neu übersetzt werden, was mehrere Stunden dauern kann. Dieser Umstand kann zu sehr langen Entwicklungszyklen von FPGA-basierten Echtzeitsimulationen führen.

Für einige FPGAs ist es möglich, zu Debug-Zwecken den kompletten Zustand des FPGA einzufrieren und auszulesen. Durch das geschlossene Ein-/Ausgabeverhalten des FPGAs ist es jedoch nicht möglich, analog zum Hauptspeicher eines Rechenknotens beliebig auf Modellzustände zuzugreifen, d.h. die Signale im Betrieb aus dem FPGA auszulesen und diese ggf. zu verändern. Ein Auslesen von Signalen aus dem FPGA kann beispielsweise über ein Readback, der Daten aus der Arbeitsebene des FPGAs in die Konfigurationsebene kopiert und von dort ausliest, erfolgen. Entsprechend können prinzipiell beliebige Registerdaten aus dem FPGA ausgelesen werden. Umgekehrt können über partielle Re-Konfiguration Daten aus der Konfigurationsebene des FPGAs in dessen Arbeitsebene kopiert werden, um Registerdaten zu verändern. Allerdings sind nicht alle Signale über Register zugreifbar.

Ein bestehendes Problem im Zusammenhang mit Readback ist, dass erst nach dem Ende des Build-Prozesses feststeht, welche Signale zurückgelesen werden können. Dies ist jedoch problematisch, da der Prozess des Modellierens und Buildens des FPGA-Programms zeitintensiv ist. Um nicht rücklesbare relevante Signale rücklesbar zu machen und im Betrieb des FPGAs auf alle relevanten Daten zugreifen zu können, ist dann eine explizite Modellierung beispielsweise von Registern zum Auslesen dieser Signal erforderlich.

Ausgehend von dem oben genannten Stand der Technik liegt der Erfindung somit die Aufgabe zugrunde, ein Verfahren der oben genannten Art anzugeben, das die Bestimmung von Modellsignalen eines FPGA-Programms, die nach einem FPGA-Build mit einem Readback aus dem FPGA auslesbar sind, erleichtert, Entwicklungszeiten für FPGA-Programme reduziert und eine hohe Flexibilität im Auslesen und/oder Verändern von Signalwerten aufweist.

Die Lösung der Aufgabe erfolgt erfindungsgemäß durch die Merkmale der unabhängigen Ansprüche. Vorteilhafte Ausgestaltungen der Erfindung sind in den Unteransprüchen angegeben.

Erfindungsgemäß ist somit ein Verfahren zur automatischen Bestimmung von Modellsignalen eines FPGA-Programms, die nach einem FPGA-Build mit einem Readback aus dem FPGA auslesbar sind, angegeben. Das Verfahren umfasst die Schritte Erzeugen eines FPGA-Modells, und Erzeugen eines FPGA-Codes aus dem FPGA-Modell, wobei das Verfahren vor dem Abschluss des Schritts der Erzeugung des FPGA-Codes aus dem FPGA-Modell den zusätzlichen Schritt des automatischen Analysierens zur Erkennung von aus dem FPGA mit einem Readback auslesbaren Signalen umfasst, und das Verfahren den Schritt des Ausgebens von aus dem FPGA mit einem Readback auslesbaren Signalen umfasst.

Erfindungsgemäß ist außerdem eine Datenverarbeitungseinrichtung angegeben, wobei die Datenverarbeitungseinrichtung zur Durchführung des obigen Verfahrens ausgeführt ist.

Erfindungsgemäß ist weiterhin ein Computerprogrammprodukt mit Computer-implementierten Anweisungen angegeben, das nach dem Laden und Ausführen in einer geeigneten Datenverarbeitungseinrichtung die Schritte des obigen Verfahrens ausführt.

Erfindungsgemäß ist ebenfalls ein digitales Speichermedium mit elektronisch auslesbaren Steuersignalen angegeben, wobei die Steuersignale so mit einer programmierbaren Datenverarbeitungseinrichtung zusammenwirken können, dass das obige Verfahren ausgeführt wird.

Grundidee der vorliegenden Erfindung ist es also, bereits vor dem Abschluss der Erzeugung des FPGA-Codes aus dem FPGA-Modell solche Signale zu erkennen, die aus dem FPGA mit einem Readback auslesbar sind. Durch die automatische Erkennung dieser Signale können solche Signale beispielsweise einem Modellierer, der das FPGA-Modell erzeugt, angezeigt werden, sodass dieser bereits vor dem Abschluss der Erzeugung des FPGA-Codes aus dem FPGA-Modell geeignete Maßnahmen ergreifen kann, beispielsweise durch das Anpassen des FPGA-Modells, um benötigte Signale mit einem Readback auslesbar zu implementieren.

Nach einem FPGA-Build wird der erzeugte FPGA-Code auf das FPGA übertragen, sodass er dort ausgeführt werden kann. Dort sind Readback Signale aus dem FPGA mittels Readback auslesbar, wobei die auslesbaren Signale den mittels Readback auslesbaren Modellsignalen entsprechen.

Das Erzeugen eines FPGA-Modells ist ein initialer Schritt zum Erzeugen des FPGA-Codes. Es wird auf übliche Weise ein Modell erstellt, welches die zu realisierende Funktion des FPGAs beschreibt. Das Erstellen eines FPGA-Modells als solches ist dem Fachmann bekannt und kann als Teil eines Gesamtmodells, das ein CPU-Modell für Komponenten, die auf einer CPU eines Rechenknotens durchgeführt werden, umfasst, erfolgen.

Das Erzeugen des FPGA-Codes aus dem FPGA-Modell schließt sich an das Erzeugen des FPGA-Modells an. Dabei wird als FPGA-Code eine FPGA Hardware-Konfiguration basierend auf dem FPGA Modell in einer Hardwarebeschreibungssprache erzeugt. Das Erzeugen des FPGA-Codes umfasst üblicherweise einen Build-Prozess mit einer Mehrzahl einzelner Schritte, die üblicherweise separat in einer bestimmten Reihenfolge durchgeführt werden. Aufgrund der Mehrzahl einzelner Schritte beim Erzeugen des FPGA-Codes aus dem FPGA-Modell kann die automatische Analyse zu verschiedenen Zeitpunkten während des Erzeugens des FPGA-Codes durchgeführt werden, soweit die Schritte in sich abgeschlossen sind und ein Zwischenergebnis erzeugt wird, welches automatisch analysierbar ist. Das Erzeugen des FPGA-Codes aus dem FPGA-Modell als solches ist dem Fachmann bekannt.

Das automatische Analysieren zur Erkennung von aus dem FPGA mit einem Readback auslesbaren Signalen kann auf unterschiedliche Weise und zu unterschiedlichen Phasen während des Erzeugens des FPGA-Codes aus dem FPGA-Modell erfolgen. Details hierzu sind nachstehend angegeben.

Das Ausgeben der aus dem FPGA mit einem Readback auslesbaren Signale erfolgt vorzugsweise unmittelbar nach Analyse, so dass frühzeitig während des Erzeugen des FPGA-Codes aus dem FPGA-Modell ersichtlich ist, welche Signale mit einem Readback aus dem FPGA auslesbar sind. Das Ausgeben der aus dem FPGA mit einem Readback auslesbaren Signale kann auf prinzipiell beliebige Weise erfolgen, beispielsweise in der Form einer Liste der aus dem FPGA auslesbaren Signale. Das Ausgeben kann beispielsweise in einer Entwicklungsumgebung zum Erzeugen des FPGA-Codes erfolgen. Üblicherweise wird das FPGA-Modell in der Entwicklungsumgebung erstellt.

In vorteilhafter Ausgestaltung der Erfindung umfasst der Schritt des automatischen Analysierens zur Erkennung von aus dem FPGA mit einem Readback auslesbaren Signalen das Erfassen einer Implementierung eines Registers zum Speichern des Signals in dem FPGA. Ein in einem Register gespeicherter Signalwert kann mit dem Readback ausgelesen werden, so dass das Erfassen eines Register in einem Signalpfad eines Signals indiziert, dass das entsprechende Signal in dem FPGA auslesbar ist. Dabei gilt als Speichern des Signals auch ein Zwischenspeichern, wenn das Register lediglich verwendet wird, um während der Verarbeitung des Signals dessen Wert z.B. temporär zu speichern.

In vorteilhafter Ausgestaltung der Erfindung umfasst der Schritt des Erfassens einer Implementierung eines Registers zum Speichern des Signals in dem FPGA das Erfassen einer Implementierung eines Verzögerungsgliedes für das Signal. Das Verzögerungsglied des Modells führt eine Verarbeitung eines Signals durch, die ein Zwischenspeichern des Signalwertes erfordert. Entsprechend erfordert die Implementierung eines Verzögerungsgliedes des Modells die Implementierung eines Registers im Signalpfad, welches mit einem Readback ausgelesen werden kann.

In vorteilhafter Ausgestaltung der Erfindung umfasst der Schritt des automatischen Analysierens zur Erkennung von aus dem FPGA mit einem Readback auslesbaren Signalen das Analysieren des FPGA-Modells zur Erkennung von aus dem FPGA mit einem Readback auslesbaren Signalen. Das FPGA-Modell dient als Basis für die Erzeugung des FPGA-Codes. Ein automatisches Analysieren kann bereits auf Basis des FPGA-Modells durchgeführt werden, da besonders bei umfangreichen und komplexen Modellen einzelne Signal nur schwer nachverfolgbar sind. Auch kann das FPGA-Modell einzelne abgeschlossene Blöcke enthalten, die ein Nachverfolgen eines Signalpfads für einen Modellierer erschweren. Bei einer automatischen Analyse können Signalpfade automatisch verfolgt werden, so dass an einer beliebigen Stelle eines Signalpfads vorliegende Implementierungen, die ein Auslesen des entsprechenden Signals mit einem Readback ermöglichen, erkannt und gesammelt werden können. Dadurch kann beispielsweise eine Implementierung eines Registers zum Speichern oder Zwischenspeichern des Signalwertes an einer beliebigen Stelle des Signalpfads eines Signals automatisch erfasst werden, woraus sich ergibt, dass das entsprechende Signal mit einem Readback auslesbar ist. Die Analyse des FPGA-Modells kann bereits durchgeführt werden, bevor andere Schritte zur Erzeugung des FPGA-Codes durchgeführt wurden, sodass diese automatische Analyse sehr effizient ist.

In vorteilhafter Ausgestaltung der Erfindung umfasst der Schritt des Erzeugens eines FPGA-Modells das Erzeugen eines hierarchischen FPGA-Modells mit einem übergeordneten Teilsystem und wenigstens einem untergeordneten Teilsystem, und der Schritt des automatischen Analysierens zur Erkennung von aus dem FPGA mit einem Readback auslesbaren Signalen umfasst ein automatisches rekursives Analysieren des FPGA-Modells beginnend bei dem übergeordneten Teilsystem. Somit können in dem FPGA-Modell funktionale Blöcke als Teilsystem gebildet werden, welche die Erstellung des FPGA-Modells erleichtern. So können die Teilsysteme leicht wiederverwendet werden. Außerdem verbessert die Verwendung von Teilsystemen die Übersichtlichkeit des FPGA-Modells, da auf einer obersten Ebene des hierarchischen FPGA-Modells teilweise nur wenige Blöcke dargestellt werden müssen. Das automatische rekursive Analysieren des FPGA-Modells unterstützt diese Art der Erstellung des FPGA-Modells, indem bei der Analyse alle Teilsysteme, also beispielsweise die funktionalen Blöcke, rekursiv analysiert werden.

In vorteilhafter Ausgestaltung der Erfindung umfasst der Schritt des automatischen rekursiven Analysierens des FPGA-Modells beginnend bei dem übergeordneten Teilsystem das Ermitteln von identischen Signalen in dem übergeordneten und untergeordneten Teilsystem. Somit können beispielsweise Ausgangssignale eines Teilsystems, deren Implementierung beispielsweise nicht mit einem Readback auslesbar ist, in einem untergeordneten Teilsystem eine Implementierung aufweisen, durch welche das Signal auf zunächst nicht ersichtliche Weise, d.h. auf im übergeordneten Teilsystem nicht ersichtliche Weise, mit einem Readback auslesbar ist. Besonders bevorzugt werden Signale zwischen dem übergeordneten und dem untergeordneten Teilsystem nachverfolgt, wodurch eine einfache Analyse eines bestimmten Signals erfolgen kann, ohne dass eine spätere Zuordnung von Signalen der hierarchischen Teilsysteme erfolgen muss.

In vorteilhafter Ausgestaltung der Erfindung umfasst der Schritt des Erzeugens eines FPGA-Codes aus dem FPGA-Modell eine Synthese zur Erzeugung einer Netzliste, und der Schritt des automatischen Analysierens zur Erkennung von aus dem FPGA mit einem Readback auslesbaren Signalen umfasst das Analysieren der Netzliste zur Erkennung von aus dem FPGA mit einem Readback auslesbaren Signalen. Die Synthese zur Erzeugung der Netzliste ist üblicherweise ein Schritt, der unmittelbar von dem FPGA-Modell ausgeht und somit in einer frühen, üblicherweise einer ersten Phase der Erzeugung des FPGA-Codes erfolgt. Entsprechend kann eine Analyse zu einem frühen Zeitpunkt bei der Erstellung des FPGA-Codes erfolgen und es kann während der Erzeugung des FPGA-Codes frühzeitig erkannt werden, welche Signale aus dem FPGA durch ein Readback auslesbar sind. Bei der Synthese zur Erzeugung einer Netzliste wird vorzugsweise in einem Synthesetool die High-Level Beschreibung des Systems gemäß des FPGA-Modells in eine Netzliste transformiert. Nach der Synthese steht typischerweise bereits fest, welche Signale auf Register abgebildet werden, wobei die konkrete Ausprägung jedoch erst nach dem Mapping auf die Ziel-Technologie bekannt ist. Der Schritt der Synthese zur Erzeugung einer Netzliste ist bei der Erzeugung von FPGA-Code aus dem FPGA-Modell prinzipiell bekannt und braucht daher nicht weiter beschrieben zu werden.

In vorteilhafter Ausgestaltung der Erfindung umfasst der Schritt des Erzeugens eines FPGA-Codes aus dem FPGA-Modell wenigstens einen der Schritte "Map", "Place" und "Route", und der Schritt des automatischen Analysierens zur Erkennung von aus dem FPGA mit einem Readback auslesbaren Signalen umfasst das entsprechende Analysieren des Ergebnisses von wenigstens einem der Schritte "Map", "Place" und "Route". Bei der Erzeugung des FPGA-Codes aus dem FPGA-Modell stellen die Schritte "Map", "Place" und "Route" unabhängige Schritte dar, die jeweils einzeln durchgeführt werden, und deren Ergebnis jeweils individuell analysiert werden kann, um mit einem Readback auslesbare Signale zu identifizieren. So kann also im Wesentlichen zu einem beliebigen Zeitpunkt bei der Erzeugung des FPGA-Codes eine Analyse durchgeführt werden, welche Signale im FPGA-Code mit einem Readback auslesbar sind. Üblicherweise werden die Schritte "Map", "Place" und "Route" in der hier angegebenen Reihenfolge durchgeführt, d.h. zuerst der Schritt "Map", dann der Schritt "Place" und schließlich der Schritt "Route". Bevorzugt erfolgt die Analyse so früh wie möglich während der Erzeugung des FPGA-Codes, so dass möglichst frühzeitig erkannt werden kann, welche Signale in dem FPGA-Code mit einem Readback ausgelesen werden können. Somit können ggf. erforderliche Anpassung des FPGA-Modells frühzeitig erfolgen, was bei der meist sehr zeitintensiven Erzeugung von FPGA-Code aus dem FPGA-Modell vorteilhaft ist. Die Schritte "Map", "Place" und "Route" sind bei der Erzeugung von FPGA-Code aus dem FPGA-Modell prinzipiell bekannt und werden daher nicht weiter beschrieben.

In vorteilhafter Ausgestaltung der Erfindung umfasst der Schritt des automatischen Analysierens zur Erkennung von aus dem FPGA mit einem Readback auslesbaren Signalen wenigstens zwei der Schritte aus der Gruppe des Analysierens des FPGA-Modells zur Erkennung von aus dem FPGA mit einem Readback auslesbaren Signalen, des Analysierens der Netzliste zur Erkennung von aus dem FPGA mit einem Readback auslesbaren Signalen, und des Analysierens der Ergebnisse von einem der Schritte "Map", "Place" und/oder "Route", und der Schritt des automatischen Analysierens zur Erkennung von aus dem FPGA mit einem Readback auslesbaren Signalen umfasst das Vergleichen der Erkennung von aus dem FPGA mit einem Readback auslesbaren Signalen gemäß der wenigstens zwei Schritte. Durch das Vergleichen der Erkennung von aus dem FPGA mit einem Readback auslesbaren Signalen gemäß der wenigstens zwei Schritte kann die Qualität der Erkennung von aus dem FPGA auslesbaren Signalen erhöht werden. Beispielsweise kann der Einfluss von automatischen Optimierungen während der Erstellung des FPGA-Codes reduziert werden. Dadurch führt das beschriebene mehrstufige Verfahren zu einer Zeitersparnis im Entwicklungszyklus. Die Schritte "Map", "Place" und/oder "Route" stellen dabei unabhängige Schritte dar, die jeweils einzeln durchgeführt werden, und deren Ergebnis jeweils individuell analysiert werden kann, um mit einem Readback auslesbare Signale zu identifizieren. Somit kann das Vergleichen der Erkennung von aus dem FPGA mit einem Readback auslesbaren Signalen gemäß der wenigstens zwei Schritte das Vergleichen der Erkennung von aus dem FPGA mit einem Readback auslesbaren Signalen gemäß jedem der einzelnen Schritte "Map", "Place" und/oder "Route" umfassen. Vorzugsweise wird eine Warnung erzeugt, wenn sich bei dem Vergleich herausstellt, dass ein Signal bei dem einen Analyseschritt auslesbar ist, aber nicht bei dem anderen.

Vorzugsweise werden die Schritte des Analysierens des FPGA-Modells zur Erkennung von aus dem FPGA mit einem Readback auslesbaren Signalen und des Analysierens der Netzliste zur Erkennung von aus dem FPGA mit einem Readback auslesbaren Signalen durchgeführt, und bei dem Schritt des Vergleichens der Erkennung von aus dem FPGA mit einem Readback auslesbaren Signalen wird die Erkennung von aus dem FPGA mit einem Readback auslesbaren Signalen durch das automatische Analysieren des FPGA-Modells mit der Erkennung von aus dem FPGA mit einem Readback auslesbaren Signalen durch das automatische Analysieren der Netzliste verglichen. Die beiden Schritte des Erstellens des FPGA-Modells und des Erzeugens der Netzliste haben großen Einfluss auf die Implementierung von Registern zum Speichern oder Zwischenspeichern von Signalen, so dass sich durch die Erkennung von aus dem FPGA auslesbaren Signalen nach diesen beiden Schritten ein zuverlässige Vorhersage betreffend der Implementierung von Signalen, die mit einem Readback auslesbar sind, treffen lässt. Üblicherweise transformiert ein Synthesetool die High-Level Beschreibung des Systems als FPGA-Modell in eine Netzliste. Nach diesem Schritt steht typischerweise bereits fest, welche Signale auf Register abgebildet werden. Die konkrete Ausprägung ist jedoch erst nach dem Mapping auf die Ziel-Technologie bekannt. Ein Abgleich mit den Ergebnissen aus der vorrangegangenen Prognose mit der Syntheseergebnissen in Form einer Netzliste steigert die Qualität der Erkennung von mit einem Readback auslesbaren Signalen deutlich, so dass das beschriebene zwei-stufige Verfahren zu einer deutlichen Zeitersparnis im Entwicklungszyklus führt. Die Implementierungsschritte "Map", "Place" und "Route" müssen nicht durchgeführt werden, um festzustellen, ob ein Modellsignal auf ein rücklesbares FPGA-Element abgebildet wird.

In vorteilhafter Ausgestaltung der Erfindung umfasst der Schritt des Erzeugens eines FPGA-Modells das Markieren eines Modellsignals in dem FPGA-Modell zum Auslesen, und der Schritt des Ausgebens von aus dem FPGA mit einem Readback auslesbaren Signalen umfasst das Überprüfen der aus dem FPGA mit einem Readback auslesbaren Signale auf das markierte Modellsignal und das Ausgeben einer Warnung, wenn die mit einem Readback auslesbaren Signale nicht das markierte Modellsignal umfassen. Somit kann ein Modellierer oder ein Anwender/Nutzer eines FPGA-Modells bereits vor dem Erzeugen des FPGA-Codes Modellsignale definieren, die auslesbar sein sollen. Aufgrund der üblicherweise großen Anzahl von Signalen eines FPGA-Modells muss der Nutzer somit nicht alle Signale einzeln überprüfen, sondern kann anhand der Ausgabe der Warnung unmittelbar erkennen, dass ein gewünschtes Modellsignal zum Auslesen mittels Readback nicht zur Verfügung steht. Die Warnung kann auf unterschiedliche Weise erzeugt werden, beispielsweise in der Entwicklungsumgebung, in der das Modellsignal markiert wurde. Vorzugsweise wird an der Markierung des Modellsignals eine Warnung erzeugt.

In vorteilhafter Ausgestaltung der Erfindung umfasst der Schritt des Erzeugens eines FPGA-Modells das Markieren eines Modellsignals zum Auslesen in dem FPGA-Modell, und der Schritt des Erzeugens eines FPGA-Codes aus dem FPGA-Modell umfasst das automatische Implementieren des Modellsignals zum Auslesen als mit einem Readback auslesbares Signal. Somit kann ein Modellierer oder ein Anwender/Nutzer eines FPGA-Modells bereits vor dem Erzeugen des FPGA-Codes Modellsignale definieren, die auslesbar sein sollen, sodass dies bei dem Erzeugen des FPGA-Codes aus dem FPGA-Modell automatisch berücksichtigt werden kann. Änderungen am FPGA-Modell sind dabei nicht erforderlich, sodass Fehler bei der Implementierung reduziert bzw. ausgeschlossen werden können. Aufgrund der üblicherweise großen Anzahl von Signalen eines FPGA-Modells muss der Nutzer somit auch nicht alle als auslesbar gewünschten Signale einzeln derart implementieren, dass sie mittels Readback auslesbar sind, sondern kann anhand der Markierung einfach definieren, dass ein gewünschtes Modellsignal zum Auslesen mittels Readback zur Verfügung stehen soll.

Vorzugsweise kann dabei automatisch in einem der Schritte des Erzeugens des FPGA-Codes eine Implementierung erfolgen, die es erlaubt, das markierte Signal auszulesen, beispielsweise durch die Implementierung eines Registers zum Zwischenspeichern des Signals. Vorzugsweise wird außerdem eine Warnung ausgegeben, falls die automatische Implementierung des Modellsignals zum Auslesen mit einem Readback scheitert. Dazu kann wie zuvor beschrieben ermittelt werden, welche Modellsignale mit einem Readback auslesbar sind, und ein Abgleich der mit dem Readback auslesbaren Signale mit den markierten Signalen erfolgen. Wenn die mit einem Readback auslesbaren Signale nicht das markierte Signal umfassen, wird die Warnung ausgegeben.

Alternativ kann zunächst das Erzeugen des FPGA-Codes aus dem FPGA-Modell begonnen werden, und abhängig von dem automatischen Analysieren zur Erkennung von aus dem FPGA mit einem Readback auslesbaren Signalen kann zunächst überprüft werden, ob das markierte Signal bereits von den mit einem Readback auslesbaren Signalen umfasst ist. Ein explizites automatisches Implementieren des Modellsignals zum Auslesen als mit einem Readback auslesbares Signal, d.h. eine von dem Normalfall ohne markiertes Modellsignal abweichende Implementierung kann dann automatisch in einem der Schritte des Erzeugens des FPGA-Codes erfolgen, um das markierte Modellsignal automatisch als mit einem Readback auslesbar zu implementieren. Falls das markierte Signal bereits von den mit einem Readback auslesbaren Signalen umfasst ist, sind Änderungen an der Implementierung des FPGA-Codes basierend auf der Markierung des Modellsignals nicht erforderlich. Auch hier wird Vorzugsweise eine Warnung ausgegeben, falls die automatische Implementierung des Modellsignals zum Auslesen mit einem Readback scheitert.

In vorteilhafter Ausgestaltung der Erfindung umfasst der Schritt des Ausgebens von aus dem FPGA mit einem Readback auslesbaren Signalen das automatische Markieren von zu den aus dem FPGA mit einem Readback auslesbaren Signalen gehörenden Modellsignalen in dem FPGA-Modell. Somit kann ein Modellierer oder Nutzer des FPGA-Modells schnell und einfach erkennen, welche Signale er aus dem FPGA mittels Readback auslesen kann. Entsprechend kann das FPGA-Modell unmittelbar angepasst werden, um Modellsignale, die in einem aktuell aus dem FPGA-Modell resultierenden FPGA-Code nicht aus dem FPGA auslesbar, auslesbar zu machen. Das Markieren der mit einem Readback auslesbaren Signals kann beispielsweise in einer Entwicklungsumgebung zum Erzeugen des FPGA-Modells erfolgen.

Nachfolgend wird die Erfindung unter Bezugnahme auf die anliegende Zeichnung anhand bevorzugter Ausführungsformen näher erläutert.

Es zeigen
- Fig. 1: ein Ablaufdiagramm eines Verfahrens zur automatischen Bestimmung von Modellsignalen eines FPGA-Programms, die nach einem FPGA-Build mit einem Readback aus dem FPGA auslesbar sind, gemäß einer ersten, bevorzugten Ausführungsform,
- Fig. 2: eine schematische Ansicht mit einer Datenverarbeitungseinrichtung zur Erzeugung des FPGA-Codes aus einem FPGA-Modell, einem Rechenknoten mit einem FPGA zur Ausführung des FPGA-Codes, und einem Hostsystem zur Ansteuerung des Rechenknotens,
- Fig. 3: ein beispielhaftes hierarchisches FPGA-Modell, und
- Fig. 4: eine beispielhafte Implementierung einer automatischen Analyse für das hierarchische FPGA-Modell gemäß Fig. 3.

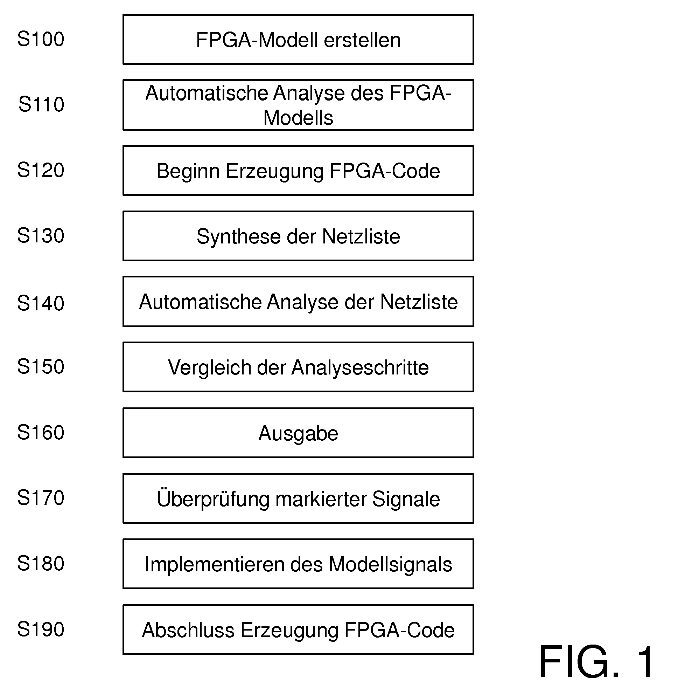

Die Figur 1 zeigt ein Ablaufdiagramm eines erfindungsgemäßen Verfahrens zur automatischen Bestimmung von Modellsignalen eines FPGA-Programms, die nach einem FPGA-Build mit einem Readback aus dem FPGA auslesbar sind, gemäß einer ersten, bevorzugten Ausführungsform.

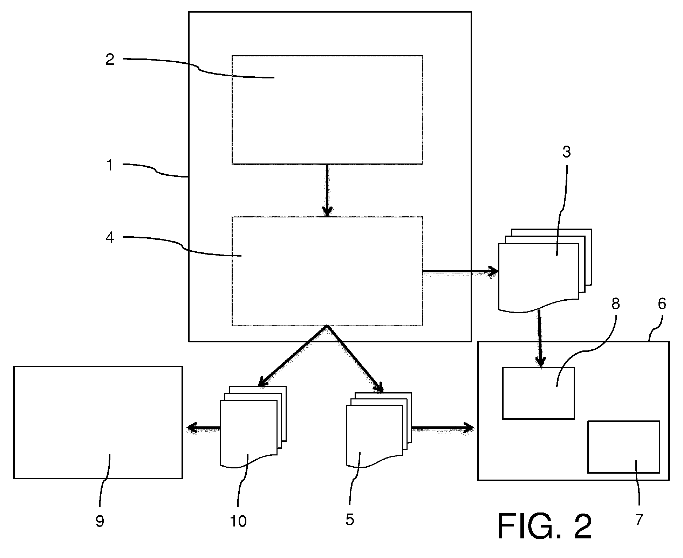

Unter Bezug auf die Fig. 2 wird zunächst das Zusammenspiel von Hardwarekomponenten zur Durchführung des Verfahrens und Ausführung des FPGA-Codes beschrieben. Die Figur 2 zeigt eine Datenverarbeitungseinrichtung 1 zur Erzeugung eines FPGA-Modells 2 und eines FPGA-Codes 3 aus dem FPGA-Modell 2, wozu ein Build 4 auf der Datenverarbeitungseinrichtung 1 durchgeführt wird. Aus dem FPGA Modell 2 wird in dem FPGA Build 4 über VHDL, einer verbreiteten Hardwarebeschreibungssprache, eine FPGA Hardware-Konfiguration als FPGA-Code 3 erzeugt. Das nachfolgend im Detail beschriebene Verfahren gemäß Fig. 1 wird auf der Datenverarbeitungseinrichtung 1 ausgeführt, wobei das Erstellen des FPGA-Modells 2 und der Build 4 prinzipiell auch auf unterschiedlichen Datenverarbeitungseinrichtungen 1 durchgeführt werden können.

Üblicherweise wird in dem Build 4 neben dem FPGA-Code 3 noch ein CPU-Code 5 erzeugt. CPU-Code 5 und FPGA-Code 3 werden aus einem gemeinsamen Modell, welches das FPGA-Modell 2 umfasst, erzeugt. Das Modell wir im vorliegenden Ausführungsbeispiel mit Simulink erzeugt. Anschließend können der CPU-Code 5 und der FPGA-Code 3 auf einen Rechenknoten 6 übertragen werden. Der Rechenknoten 6 umfasst entsprechend eine CPU 7 zur Ausführung des CPU-Codes 5 und ein FPGA 8 zur Ausführung des FPGA-Codes 3. Das FPGA 8 ist in diesem Ausführungsbeispiel ein Xilinx FPGA.

Weiterhin ist in Fig. 2 ein Hostsystem 9 zur Ansteuerung des Rechenknotens 6 dargestellt. Der Rechenknoten 6 ist mit dem Hostsystem 9 über eine nicht dargestellte Netzwerkverbindung verbunden. In dem Build 4 werden zusätzlich Tracefiles 10 erzeugt, die es dem Hostsystem 9 ermöglichen, im Betrieb des Rechenknotens 6 auf Signalwerte sowohl der CPU 7 wie auch des FPGA 8 zuzugreifen, wobei ein lesender Zugriff auf das FPGA 8 über Readback und ein schreibender Zugriff über partielle Re-Konfiguration erfolgt.

Nachfolgend wir das Verfahren zur automatischen Bestimmung von Modellsignalen eines FPGA-Programms, die nach einem FPGA-Build mit einem Readback aus dem FPGA auslesbar sind, gemäß der ersten Ausführungsform beschrieben.

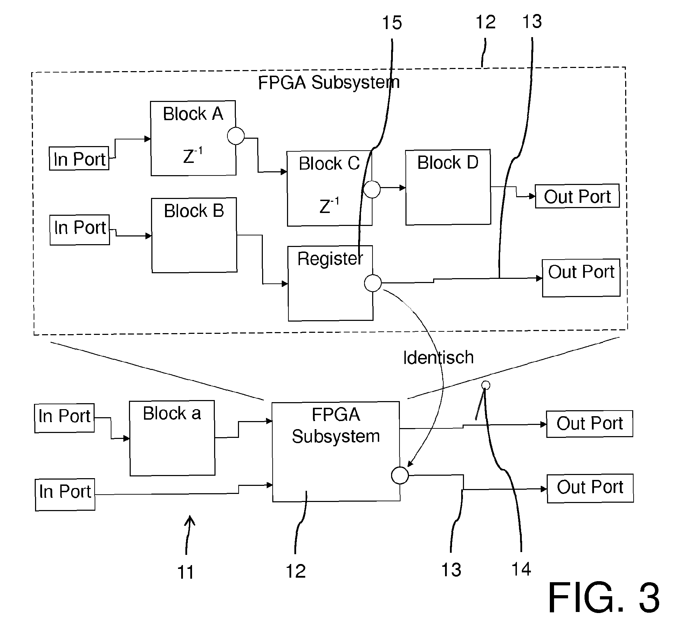

Das Verfahren beginnt in Schritt S100 mit dem Erzeugen eines FPGA-Modells 2 auf der Datenverarbeitungseinrichtung 1. Das FPGA-Modell 2 beschreibt eine mit dem FPGA 8 zu realisierende Funktion. Ein Teil eines beispielhaftes FPGA-Modell 2 ist ebenfalls in Fig. 3 dargestellt. Wie dort ersichtlich, ist das FPGA-Modell 2 ein hierarchisches FPGA-Modell 2, wobei in Fig. 3 ein übergeordnetes Teilsystem 11 mit einem untergeordneten Teilsystem 12 dargestellt ist. Die Teilsysteme 11, 12 bilden dabei einzelne abgeschlossene Blöcke.

Wie in Fig. 3 gezeigt, wird in dem übergeordneten Teilsystem 11 in einem Signalpfad 13 eine Read-Markierung 14 gesetzt, um ein Modellsignal in dem FPGA-Modell 2 zum Auslesen mit einem Readback zu markieren. Änderungen an dem FPGA-Modell 2 erfolgen nicht.

In einem Schritt S110 erfolgt ein erster Schritt eines automatischen Analysierens zur Erkennung von aus dem FPGA 8 mit einem Readback auslesbaren Signalen. Dazu wird das FPGA-Modell 2 zur Erkennung von aus dem FPGA 8 mit einem Readback auslesbaren Signalen automatisch analysiert.

Dabei werden Implementierungen eines Registers 15 zum Speichern oder Zwischenspeichern eines Signals, wie in Fig. 3 dargestellt, in dem FPGA 8 an einer beliebigen Stelle des Signalpfads 13 automatisch erfasst. Außerdem werden Implementierung eines Verzögerungsgliedes an einer beliebigen Stelle des Signalpfads 13 eines Signals automatisch erfasst. Die Signalpfade 13 werden automatisch verfolgt, so dass an einer beliebigen Stelle eines Signalpfads 13 vorliegende Implementierungen, die ein Auslesen des entsprechenden Signals mit einem Readback ermöglichen, erkannt und gesammelt werden können. Die automatische Analyse führt dabei eine rekursives Analysiere des FPGA-Modells 2 beginnend bei dem übergeordneten Teilsystem 11 durch.

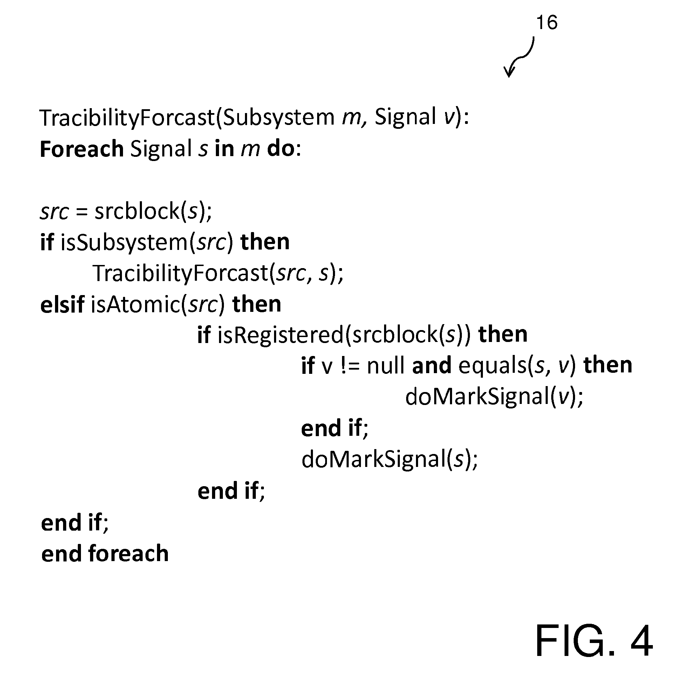

Bei der rekursiven Analyse werden identischen Signalen in dem übergeordneten und untergeordneten Teilsystem 11, 12 ermittelt. Signale, die in einem der Teilsysteme 11, 12 mit einem Readback auslesbar implementiert sind, stehen entsprechend als mit einem Readback auslesbar an beliebiger Stelle zur Verfügung. Eine Implementierung der rekursiven Analyse ist in Fig. 4 dargestellt. Wie dort ersichtlich wird in einem Modul 16, das hier als TraceabilityForecast bezeichnet ist, für jedes Signal s eine Voraussage erzeugt, ob das Signal mit einem Readback auslesbar ist. Dazu wird zunächst mit einer Funktion srcblock ein Quellblock des Signals s eingelesen. Anschließend erfolgt wird mit der Überprüfung in isSubsystem überprüft, ob ein eingegebene Block ein Subsystem innerhalb des FPGA-Modells 2 darstellt. Wenn dies der Fall ist, wird die Funktion TraceabilityForecast erneut aufgerufen. Andernfalls wird in dem Schritt isAtomic überprüft, ob der der eingegebene Block kein Subsystem ist und sich somit nicht weiter in atomare Blöcke zerteilen lässt. Falls dies der Fall ist, wird in dem Schritt isRegistered überprüft, ob ein Block nach der Synthese auf ein Register 15 abgebildet wird, d.h. das Signal in einem Register 15 gespeichert oder zwischengespeichert wird. Neben den oben genannten Fällen der Implementierung eines Registers 15 oder eines Verzögerungsgliedes ist dies auch wahr, wenn der Block besitzt eine Verzögerung Zx mit x > 0 ist, oder der Block Teil einer zuvor definierten Liste, d.h. ein Spezialblock ist, für den bereits definiert wurde, dass er eine auslesbare Implementierung beinhaltet. Im Nachfolgenden Schritt wir in der Funktion equals überprüft, ob zwei Signale über eine Hierarchiestufe hinweg, d.h. also in dem übergeordneten Teilsystem 11 und in dem untergeordneten Teilsystem 12, dasselbe Signal repräsentieren. Falls dies zutrifft wird in dem Schritt doMarkSignal das Signal als mit einem Readback aus dem FPGA rücklesbar markiert und zu einer ersten Liste mit aus dem FPGA mit einem Readback auslesbaren Signalen hinzugefügt.

In einem Schritt S120 wird der Build 4 gestartet. Der Build 4 geht dabei von dem FPGA-Modell 2 aus, wobei am Ende des Build 4 der FPGA-Code erzeugt wird. Der FPGA-Code 2 ist eine FPGA Hardware-Konfiguration basierend auf dem FPGA Modell in einer Hardwarebeschreibungssprache.

In einem Schritt S130 erfolgt als erster Schritt des Build 4 eine Synthese zur Erzeugung einer Netzliste. Dabei wird in einem Synthesetool die High-Level Beschreibung des Systems gemäß des FPGA-Modells 2 in die Netzliste transformiert.

In einem Schritt S140 wird die Netzliste automatisch analysiert zur Erkennung von aus dem FPGA 8 mit einem Readback auslesbaren Signalen. Es wird eine zweite Liste mit Signalen erstellt, die nach dem Build 4 mit einem Readback aus dem FPGA 8 auslesbar sind.

In einem Schritt S150 werden die Listen aus den Schritten S110 und S120, d.h. die erste und die zweite Liste mit Signalen, die mittels Readback aus dem FPGA 8 auslesbar sind, verglichen. Es wird eine konsolidierte Liste mit Signalen, die mittels Readback aus dem FPGA 8 auslesbar sind, erstellt, wobei die konsolidierte Liste Signale enthält, die sowohl in der ersten wie auch in der zweiten Liste als mittels Readback aus dem FPGA 8 auslesbar enthalten sind.

Für Signale, die nur in einer der beiden Listen enthalten sind, die also nicht in die konsolidierte Liste übernommen wurden, wird eine Warnung erzeugt, die beispielsweise in dem FPGA-Modell 2 angezeigt wird.

In einem Schritt S160 erfolgt das Ausgebens der aus dem FPGA 8 mit einem Readback auslesbaren Signale. Das Ausgeben der aus dem FPGA 8 mit einem Readback auslesbaren Signale erfolgt in der Form einer Liste in der Entwicklungsumgebung zum Erzeugen des FPGA-Codes. Zusätzlich werden in dem FPGA-Modell 2 zu den aus dem FPGA 8 mit einem Readback auslesbaren Signalen gehörenden Modellsignale in dem FPGA-Modell 2 automatisch markiert.

In einem Schritt S170 wird überprüft, ob alle mit einer Read-Markierung 14 markierten Signale aus dem FPGA 8 mit einem Readback auslesbar sind, also Teil der konsolidierten Liste sind. Bei einem mit einer Read-Markierung 14 markierten Signal, das nicht mit einem Readback auslesbar ist, wird eine Warnung ausgegeben, indem an der Read-Markierung 14 des Modellsignals eine Warnung erzeugt und angezeigt wird.

In einem Schritt S180 erfolgt ein automatisches Implementieren des Modellsignals als mit einem Readback auslesbares Signal in dem FPGA 8, wenn die Überprüfung in Schritt S170 ergeben hat, dass dieses mit der Read-Markierung 14 markierte Signal aus dem FPGA 8 nicht mit einem Readback auslesbar ist. Dazu wird automatisch in dem Signalpfad 13 diese Signals ein Register 15 zum Zwischenspeichern des Signalwerts implementiert. Falls die automatische Implementierung des Registers 15 scheitert, wird eine entsprechende Warnung ausgegeben.

In Schritt S190 wird die Erzeugung des FPGA-Codes 3 abgeschlossen. Entsprechend werden in dem Build 4 die Schritte "Map", "Place" und "Route" durchgeführt und der FPGA-Code 3 erzeugt.

In Übereinstimmung mit dem Verfahren zur Bestimmung von Signalen eines FPGAs 8, die nach der Erzeugung des FPGA-Codes 3 mit einem Readback aus dem FPGA 8 auslesbar sind, ergibt sich, dass diese Signale auch über eine entsprechende partielle Re-Konfiguration des FPGA 8 geschrieben werden können, soweit dies von dem FPGA 8 unterstützt wird. In einer zweiten Ausführungsform der Erfindung wird das vorbeschriebene Verfahren durchgeführt, um Signale zu bestimmen, die nach der Erzeugung des FPGA-Codes 3 mit einer partiellen Re-Konfiguration veränderbar sind. Dies setzt lediglich voraus, dass das FPGA 8 entsprechende Manipulationsmöglichkeiten wie die genannte partielle Re-Konfiguration bereitstellt.

Das Verfahren ist als Computerprogrammprodukt mit Computer-implementierten Anweisungen implementiert, das nach dem Laden und Ausführen in der Datenverarbeitungseinrichtung 1 die Schritte des obigen Verfahrens ausführt.

Ein digitales Speichermedium stellt elektronisch auslesbare Steuersignale bereit, die so mit der Datenverarbeitungseinrichtung 1 zusammenwirken, dass das obige Verfahren auf der Datenverarbeitungseinrichtung 1 ausgeführt wird.

### Bezugszeichenliste

- Datenverarbeitungseinrichtung: 1
- FPGA-Modell: 2
- FPGA-Code: 3
- Build: 4
- CPU-Code: 5
- Rechenknoten: 6
- CPU: 7
- FPGA: 8
- Hostsystem: 9
- Tracefile: 10
- übergeordnetes Teilsystem: 11
- untergeordnetes Teilsystem: 12
- Signalpfad: 13
- Read-Markierung: 14
- Register: 15
- Modul, TraceabilityForecast: 16

## Patentansprüche

1. Verfahren zur automatischen Bestimmung von Modellsignalen eines FPGA-Programms, die nach einem FPGA-Build (4) mit einem Readback aus dem FPGA (8) auslesbar sind, umfassend die Schritte
Erzeugen eines FPGA-Modells (2), und
Erzeugen eines FPGA-Codes (3) aus dem FPGA-Modell (2),
wobei
das Verfahren vor dem Abschluss des Schritts der Erzeugung des FPGA-Codes (3) aus dem FPGA-Modell (2) den zusätzlichen Schritt des automatischen Analysierens zur Erkennung von aus dem FPGA (8) mit einem Readback auslesbaren Signalen umfasst, und
das Verfahren den Schritt des Ausgebens von aus dem FPGA (8) mit einem Readback auslesbaren Signalen umfasst.

2. Verfahren nach Anspruch 1, **dadurch gekennzeichnet, dass**
der Schritt des automatischen Analysierens zur Erkennung von aus dem FPGA (8) mit einem Readback auslesbaren Signalen das Erfassen einer Implementierung eines Registers (15) zum Speichern des Signals in dem FPGA (8) umfasst.

3. Verfahren nach Anspruch 2, **dadurch gekennzeichnet, dass**
der Schritt des Erfassens einer Implementierung eines Registers (15) zum Speichern des Signals in dem FPGA (8) das Erfassen einer Implementierung eines Verzögerungsgliedes für das Signal umfasst.

4. Verfahren nach einem der vorhergehenden Ansprüche, **dadurch gekennzeichnet, dass**
der Schritt des automatischen Analysierens zur Erkennung von aus dem FPGA (8) mit einem Readback auslesbaren Signalen das Analysieren des FPGA-Modells (2) zur Erkennung von aus dem FPGA (8) mit einem Readback auslesbaren Signalen umfasst.

5. Verfahren nach Anspruch 4, **dadurch gekennzeichnet, dass**
der Schritt des Erzeugens eines FPGA-Modells (2) das Erzeugen eines hierarchischen FPGA-Modells (2) mit einem übergeordneten Teilsystem (11) und wenigstens einem untergeordneten Teilsystem (12) umfasst, und
der Schritt des automatischen Analysierens zur Erkennung von aus dem FPGA (8) mit einem Readback auslesbaren Signalen ein automatisches rekursives Analysieren des FPGA-Modells (2) beginnend bei dem übergeordneten Teilsystem (11) umfasst.

6. Verfahren nach Anspruch 5, **dadurch gekennzeichnet, dass**
der Schritt des automatischen rekursiven Analysierens des FPGA-Modells (2) beginnend bei dem übergeordneten Teilsystem (11) das Ermitteln von identischen Signalen in dem übergeordneten und untergeordneten Teilsystem (11, 12) umfasst.

7. Verfahren nach einem der vorhergehenden Ansprüche, **dadurch gekennzeichnet, dass** der Schritt des Erzeugens eines FPGA-Codes (3) aus dem FPGA-Modell (2) eine Synthese zur Erzeugung einer Netzliste umfasst, und
der Schritt des automatischen Analysierens zur Erkennung von aus dem FPGA (8) mit einem Readback auslesbaren Signalen das Analysieren der Netzliste zur Erkennung von aus dem FPGA (8) mit einem Readback auslesbaren Signalen umfasst.

8. Verfahren nach einem der vorhergehenden Ansprüche, **dadurch gekennzeichnet, dass**
der Schritt des Erzeugens eines FPGA-Codes (3) aus dem FPGA-Modell (2) wenigstens einen der Schritte "Map", "Place" und "Route" umfasst, und
der Schritt des automatischen Analysierens zur Erkennung von aus dem FPGA (8) mit einem Readback auslesbaren Signalen das entsprechende Analysieren des Ergebnisses von wenigstens einem der Schritte "Map", "Place" und "Route" umfasst.

9. Verfahren nach einem der vorhergehenden Ansprüche, **dadurch gekennzeichnet, dass**
der Schritt des automatischen Analysierens zur Erkennung von aus dem FPGA (8) mit einem Readback auslesbaren Signalen wenigstens zwei der Schritte aus der Gruppe des Analysierens des FPGA-Modells (2) zur Erkennung von aus dem FPGA (8) mit einem Readback auslesbaren Signalen,
des Analysierens der Netzliste zur Erkennung von aus dem FPGA (8) mit einem Readback auslesbaren Signalen, und
des Analysierens der Ergebnisse von einem der Schritte "Map", "Place" und/oder "Route" umfasst, und
der Schritt des automatischen Analysierens zur Erkennung von aus dem FPGA (8) mit einem Readback auslesbaren Signalen das Vergleichen der Erkennung von aus dem FPGA (8) mit einem Readback auslesbaren Signalen gemäß der wenigstens zwei Schritte umfasst.

10. Verfahren nach einem der vorhergehenden Ansprüche, **dadurch gekennzeichnet, dass**
der Schritt des Erzeugens eines FPGA-Modells (2) das Markieren eines Modellsignals in dem FPGA-Modell (2) zum Auslesen umfasst, und
der Schritt des Ausgebens von aus dem FPGA (8) mit einem Readback auslesbaren Signalen das Überprüfen der aus dem FPGA (8) mit einem Readback auslesbaren Signale auf das markierte Modellsignal und das Ausgeben einer Warnung, wenn die mit einem Readback auslesbaren Signale nicht das markierte Modellsignal umfassen, aufweist.

11. Verfahren nach einem der vorhergehenden Ansprüche, **dadurch gekennzeichnet, dass**
der Schritt des Erzeugens eines FPGA-Modells (2) das Markieren eines Modellsignals zum Auslesen in dem FPGA-Modell (2) umfasst, und
der Schritt des Erzeugens eines FPGA-Codes (3) aus dem FPGA-Modell (2) das automatische Implementieren des Modellsignals zum Auslesen als mit einem Readback auslesbares Signal umfasst.

12. Verfahren nach einem der vorhergehenden Ansprüche, **dadurch gekennzeichnet, dass**
der Schritt des Ausgebens von aus dem FPGA (8) mit einem Readback auslesbaren Signalen das automatische Markieren von zu den aus dem FPGA (8) mit einem Readback auslesbaren Signalen gehörenden Modellsignalen in dem FPGA-Modell (2) umfasst.

13. Datenverarbeitungseinrichtung (1), wobei
die Datenverarbeitungseinrichtung (1) zur Durchführung des Verfahrens nach einem der vorhergehenden Ansprüche 1 bis 12 ausgeführt ist.

14. Computerprogrammprodukt mit Computer-implementierten Anweisungen, das nach dem Laden und Ausführen in einer geeigneten Datenverarbeitungseinrichtung (1) die Schritte des Verfahrens nach einem der vorhergehenden Ansprüche 1 bis 12 ausführt.

15. Digitales Speichermedium mit elektronisch auslesbaren Steuersignalen, die so mit einer programmierbaren Datenverarbeitungseinrichtung (1) zusammenwirken können, dass das Verfahren nach einem der vorhergehenden Ansprüche 1 bis 12 auf der Datenverarbeitungseinrichtung (1) ausgeführt wird.
